# EUROPEAN PATENT APPLICATION

(11) **EP 2 403 002 A1**
(43) Date of publication of application: **04.01.2012**
(21) Application number: 09840822.2
(22) Date of filing: 11.08.2009
(51) Int. Cl.: H01L 31/0236, H01L 31/0224, H01L 31/075

(54) **PHOTOELECTRIC CONVERSION DEVICE**

(30) Priority: 27.02.2009 JP 2009047346
(71) Applicant: Mitsubishi Heavy Industries, Ltd., Tokyo 108-8215 (JP)
(72) Inventor: KOBAYASHI, Yasuyuki, Yokohama-shi Kanagawa 236-8515 (JP); SAKAI, Satoshi, Yokohama-shi Kanagawa 236-8515 (JP); GOYA, Saneyuki, Yokohama-shi Kanagawa 236-8515 (JP)
(74) Representative: Bongiovanni, Simone
(86) International application number: PCT/JP2009/064200
(87) International publication number: WO 2010/097975

(57) **Abstract**

A photovoltaic device in which, by optimizing the structures for a substrate-side transparent electrode layer, an intermediate layer, and a back electrode layer, the extracted electrical current can be increased. The photovoltaic device (100) includes at least a transparent electrode layer (2), a photovoltaic layer (3) and a back electrode layer (4) provided on a substrate (1), wherein the surface of the transparent electrode layer (2) on which the photovoltaic layer (3) is disposed includes a textured structure composed of ridges (2a) and a fine micro-texture (2b) provided on the surface of the ridges (2a), the pitch of the textured structure is not less than 1.2 µm and not more than 1.6 µm, the height of the ridges (2a) is not less than 0.2 µm and not more than 0.8 µm, the pitch between peaks in the fine micro-texture (2b) is not less than 0.05 µm and not more than 0.14 µm, and the height of peaks is not less than 0.02 µm and not more than 0.1 µm.

## Description

### Technical Field

The present invention relates to a photovoltaic device, and relates particularly to a thin-film solar cell in which the electric power generation layer is formed by deposition.

### Background Art

One known example of a photovoltaic device used in a solar cell that converts the energy from sunlight into electrical energy is a thin-film silicon-based photovoltaic device comprising a photovoltaic layer formed by using a plasma enhanced CVD method or the like to deposit thin films of a p-type silicon-based semiconductor (p-layer), an i-type silicon-based semiconductor (i-layer) and an n-type silicon-based semiconductor (n-layer).

One example of a technique for increasing the conversion efficiency of a thin-film silicon-based solar cell involves improving the photovoltaic conversion efficiency of the photovoltaic layer of the thin-film silicon-based solar cell by providing a textured structure (an uneven surface) on the surface of either the transparent electrode layer on the sunlight-incident side of the cell or the metal layer on the back of the cell. When the transparent electrode layer or the metal layer is provided with a textured structure, the incident light is scattered, thereby lengthening the light path and increasing the amount of light absorbed by the photovoltaic layer, which results in an improvement in the photovoltaic conversion efficiency.

Patent citation 1 discloses a substrate with a transparent conductive oxide film, having a structure comprising a macro-texture formed from a plurality of discontinuous ridges and a plurality of flat portions that fill the regions between the ridges formed on top of a glass substrate, wherein the surfaces of the ridges and the flat portions contain a multitude of micro-texture irregularities. The citation discloses that a pitch between ridges of 0.7 to 1.2 µm and a height for the ridges of 0.2 to 2.0 µm are particularly desirable.

Furthermore, besides improving the film quality of the thin-film silicon material (such as amorphous silicon, amorphous silicon germanium or microcrystalline silicon), other known methods of improving the conversion efficiency include the use of multi-junction photovoltaic devices having a plurality of stacked photovoltaic layers that exhibit different band gaps, and particularly triple photovoltaic devices in which three photovoltaic layers are stacked together. The main reasons for the improvement in conversion efficiency are that by combining photovoltaic layers with different band gaps, solar energy across a wide wavelength band can be utilized effectively, and the fact that photon energy conversion efficiency within each conversion element can be improved.

Patent citation 2 discloses a photovoltaic device having a photovoltaic layer in which an amorphous silicon layer as a first layer, a microcrystalline silicon layer as a second layer, and a microcrystalline silicon germanium layer as a third layer are stacked in that order from the light-incident side of the device. The citation discloses that when the germanium content of the microcrystalline silicon germanium i-layer is 40 atomic% or higher, the microcrystalline silicon germanium i-layer exhibits a band gap that is ideal for absorbing long-wavelength light, enabling a satisfactory current to be obtained from the third layer, and as a result, an improvement is observed in the overall conversion efficiency.

Patent Citation 1: Japanese Unexamined Patent Application, Publication No. 2005-347490 (claim 2, claim 5, paragraphs [0044] and [0045])
Patent Citation 2: Publication of Japanese Patent No. 3,684,041 (claim 11, claim 16, paragraphs [0198] to [0199], Table 1 and Table 2)

### Disclosure of Invention

Patent citation 1 discloses examples in which the aforementioned substrate with a transparent conductive oxide film having a surface texture structure is applied to a single-type solar cell. However, no investigations were conducted into the electrical current achieved when the aforementioned substrate was applied to a multi-junction solar cell, or when a photovoltaic layer comprising a silicon germanium i-layer was formed.

The solar cell disclosed in patent citation 2 was not an optimized structure in which the electrical current generated in each pin structure was adjusted to achieve consistency and the extracted electrical current is increased. Further, although the germanium concentration within the silicon germanium was specified as being preferably 40 atomic% or higher, a problem arises in that by using a large amount of the Ge material, which is considerably more expensive than Si, the raw material costs increase dramatically.

The present invention provides a photovoltaic device in which, by optimizing the structures for a substrate-side transparent electrode layer, an intermediate layer, and a back electrode layer, the extracted electrical current can be increased. The invention also provides a substrate comprising a transparent electrode layer structure that is ideal for increasing the extracted electrical current for the photovoltaic device.

A photovoltaic device of the present invention comprises at least a transparent electrode layer, a photovoltaic layer and a back electrode layer provided on a substrate, wherein the surface of the transparent electrode layer on which the photovoltaic layer is disposed comprises a textured structure composed of ridges and a fine micro-texture provided on the surface of the ridges, and the pitch of the textured structure provided on the transparent electrode layer is not less than 1.2 µm and not more than 1.6 µm.
In the above invention, the height of the ridges is preferably not less than 0.2 µm and not more than 0.8 µm. The pitch between peaks in the fine micro-texture is preferably not less than 0.05 µm and not more than 0.14 µm. The height of these peaks is preferably not less than 0.02 µm and not more than 0.1 µm.

A photovoltaic device in which the surface of the transparent electrode layer on which the photovoltaic layer is disposed comprises a textured structure composed of ridges and a fine micro-texture provided on the surface of the ridges, and in which the shapes of the ridges and the fine micro-texture satisfy the ranges specified above, lengthens the light path through scattering of the incident light, resulting in an increased extracted electrical current. According to the present invention, by achieving electrical current consistency while increasing the length of the light path, an increase in the extracted electrical current can be achieved even if the thickness of the photovoltaic layer is reduced. Moreover, because the photovoltaic device of the present invention enables the thickness of the photovoltaic layer to be reduced, the raw material costs associated with producing the device can be reduced.

In the present invention described above, the photovoltaic layer preferably comprises at least a first cell layer closest to the substrate and a second cell layer that is formed on top of the first cell layer, wherein a first intermediate contact layer is provided between the first cell layer and the second cell layer, the surface of the first intermediate contact layer on which the second cell layer is disposed has a textured structure represented by a sine curve, the average film thickness of the first intermediate contact layer is not less than 0.03 µm and not more than 0.09 µm, and the height of the textured structure of the first intermediate contact layer is not less than 0 µm and not more than 0.42 µm.
Furthermore, the photovoltaic layer preferably further comprises a third cell layer formed on top of the aforementioned second cell layer, wherein a second intermediate contact layer is provided between the second cell layer and the third cell layer, the surface of the second intermediate contact layer on which the third cell layer is disposed has a textured structure represented by a sine curve, the average film thickness of the second intermediate contact layer is not less than 0.03 µm and not more than 0.09 µm, and the height of the textured structure of the second intermediate contact layer is not less than 0.22 µm and not more than 0.7 µm.

In this manner, by setting the shape of the surface of the first intermediate contact layer on the side of the second cell layer, and the shape of the surface of the second intermediate contact layer on the side of the third cell layer to shapes that satisfy the ranges specified above, the film thickness of each cell layer can be reduced, and the extracted electrical current can be further increased.

In the invention described above, the photovoltaic layer preferably comprises a crystalline silicon germanium i-layer, and the germanium concentration within the crystalline silicon germanium i-layer is preferably not less than 10 atomic% and not more than 35 atomic%.

In the photovoltaic device comprising the crystalline silicon germanium i-layer, because the light path is lengthened by forming a transparent electrode layer of the structure outlined above, it was discovered that a satisfactory extracted electrical current could be achieved even when the germanium concentration within the crystalline silicon germanium i-layer was not less than 10 atomic% and not more than 35 atomic%, which represents a concentration considerably lower than that conventionally used. Furthermore, when the film thickness of the photovoltaic layer was optimized while maintaining current consistency, it was found that the crystalline silicon germanium i-layer, in particular, could be made significantly thinner than conventional film thicknesses. This is very advantageous, as it enables the raw material costs to be reduced dramatically.

Furthermore, a photovoltaic device of another aspect of the present invention comprises at least a transparent electrode layer, a photovoltaic layer and a back electrode layer provided on a substrate, wherein the surface of the transparent electrode layer on which the photovoltaic layer is disposed comprises a V-shaped textured structure, the pitch of the textured structure provided on the transparent electrode layer is not less than 0.3 µm and not more than 5 µm, the slope of a peak in the textured structure on the transparent electrode layer relative to a plane parallel to the substrate is not less than 15° and not more than 60°, the photovoltaic layer comprises a crystalline silicon germanium i-layer, and the germanium concentration within the crystalline silicon germanium i-layer is not less than 10 atomic% and not more than 35 atomic%.

A photovoltaic device in which the surface of the transparent electrode layer on the side of the photovoltaic layer is set to the shape described above lengthens the light path through scattering of the incident light, and therefore a satisfactory extracted electrical current can be achieved even when the germanium concentration within the crystalline silicon germanium i-layer is not less than 10 atomic% and not more than 35 atomic%, which represents a concentration considerably lower than that conventionally used. When the film thickness of the photovoltaic layer was optimized while maintaining current consistency, it was found that the thickness of the photovoltaic layer, and particularly the thickness of the crystalline silicon germanium i-layer, could be reduced to a value considerably less than a conventional film thickness. As a result, a photovoltaic device that exhibits a high output can be obtained, while dramatically reducing the raw material costs.

Furthermore, the present invention also provides a substrate for a photovoltaic device, wherein a transparent electrode layer comprising a transparent oxide is provided on the substrate, the surface of the transparent electrode layer on the opposite side to the substrate comprises a textured structure composed of ridges and a fine micro-texture provided on the surface of the ridges, the pitch of the textured structure on the transparent electrode layer is not less than 1.2 µm and not more than 1.6 µm, the height of the ridges is not less than 0.2 µm and not more than 0.8 µm, the pitch between peaks in the fine micro-texture is not less than 0.05 µm and not more than 0.14 µm, and the height of these peaks is not less than 0.02 µm and not more than 0.1 µm.

By using a substrate in which the surface of the transparent electrode layer on the opposite side to the substrate is set to the shape described above, a photovoltaic device having a large extracted electrical current can be fabricated even if the photovoltaic layer is thin. In particular, if the photovoltaic device has a photovoltaic layer that comprises a crystalline silicon germanium i-layer, then not only can the film thickness be reduced, but the germanium concentration can be lowered further than is conventionally possible.

By forming a transparent electrode layer with the surface structure outlined above, an increase in the extracted electrical current can be achieved while reducing the thickness of the photovoltaic layer. In particular, if the photovoltaic device has a photovoltaic layer that comprises a crystalline silicon germanium i-layer, then not only can the film thickness of the crystalline silicon germanium i-layer be reduced, but the germanium concentration within the i-layer can be lowered further than is conventionally possible, meaning a dramatic reduction in raw material costs can be realized.

### Brief Description of Drawings

[FIG. 1] A schematic view illustrating the structure of a photovoltaic device according to a first embodiment.
[FIG. 2] A schematic illustration describing one embodiment for producing a solar cell panel using a process for producing a photovoltaic device according to the first embodiment.
[FIG. 3] A schematic illustration describing one embodiment for producing a solar cell panel using a process for producing a photovoltaic device according to the first embodiment.
[FIG. 4] A schematic illustration describing one embodiment for producing a solar cell panel using a process for producing a photovoltaic device according to the first embodiment.
[FIG. 5] A schematic illustration describing one embodiment for producing a solar cell panel using a process for producing a photovoltaic device according to the first embodiment.
[FIG. 6] A graph illustrating the relationship between the pitch of a textured structure of a transparent electrode layer, and the short-circuit current of a triple solar cell according to the first embodiment.
[FIG. 7] A graph illustrating the relationship between the height of the ridges on the transparent electrode layer, and the short-circuit current of a triple solar cell according to the first embodiment.
[FIG. 8] A graph illustrating the relationship between the pitch of a fine micro-texture of the transparent electrode layer, and the short-circuit current of a triple solar cell according to the first embodiment.
[FIG. 9] A graph illustrating the relationship between the height of the fine micro-texture of the transparent electrode layer, and the short-circuit current of a triple solar cell according to the first embodiment.
[FIG. 10] A graph illustrating the relationship between the pitch of a textured shape on the surface of a substrate-side antireflection layer on the side of a first cell layer, and the short-circuit current of a triple solar cell according to the first embodiment.
[FIG. 11] A graph illustrating the relationship between the height of the textured shape on the surface of the substrate-side antireflection layer on the side of the first cell layer, and the short-circuit current of a triple solar cell according to the first embodiment.
[FIG. 12] A graph illustrating the relationship between the pitch of a textured shape on the surface of the first cell layer on the side of a first intermediate contact layer, and the short-circuit current of a triple solar cell according to the first embodiment.
[FIG. 13] A graph illustrating the relationship between the height of the textured shape on the surface of the first cell layer on the side of the first intermediate contact layer, and the short-circuit current of a triple solar cell according to the first embodiment.
[FIG. 14] A graph illustrating the relationship between the pitch of a textured shape on the surface of the first intermediate contact layer on the side of a second cell layer, and the short-circuit current of a triple solar cell according to the first embodiment.
[FIG. 15] A graph illustrating the relationship between the height of a textured shape on the surface of the first intermediate contact layer on the side of the second cell layer, and the short-circuit current of a triple solar cell according to the first embodiment.
[FIG. 16] A graph illustrating the relationship between the average film thickness of the first intermediate contact layer, and the short-circuit current of a triple solar cell according to the first embodiment.
[FIG. 17] A graph illustrating the relationship between the maximum height of the textured structure of the first intermediate contact layer, and the short-circuit current of a triple solar cell according to the first embodiment.
[FIG. 18] A graph illustrating the relationship between the average film thickness of the second intermediate contact layer, and the short-circuit current of a triple solar cell according to the first embodiment.
[FIG. 19] A graph illustrating the relationship between the height of the textured structure of the second intermediate contact layer, and the short-circuit current of a triple solar cell according to the first embodiment.
[FIG. 20] A graph illustrating the relationship between the average film thickness of a back-side transparent layer, and the short-circuit current of a triple solar cell according to the first embodiment.
[FIG. 21] A schematic view illustrating the structure of a photovoltaic device according to a second embodiment.
[FIG. 22] A graph illustrating the relationship between the average film thickness of the first intermediate contact layer, and the short-circuit current of a triple solar cell according to the second embodiment.
[FIG. 23] A graph illustrating the relationship between the height of the textured structure of the first intermediate contact layer, and the short-circuit current of a triple solar cell according to the second embodiment.
[FIG. 24] A graph illustrating the relationship between the average film thickness of the second intermediate contact layer, and the short-circuit current of a triple solar cell according to the second embodiment.
[FIG. 25] A graph illustrating the relationship between the height of the textured structure of the second intermediate contact layer, and the short-circuit current of a triple solar cell according to the second embodiment.
[FIG. 26] A graph illustrating the relationship between the average film thickness of the back-side transparent layer, and the short-circuit current of a triple solar cell according to the second embodiment.
[FIG. 27] A graph illustrating the relationship between the Ge concentration within a crystalline silicon germanium i-layer and the film thickness of the i-layer within each cell layer required to realize a short-circuit current of 11 mA/cm² for triple solar cells of an example 1 and a comparative example.
[FIG. 28] A graph illustrating the relationship between the Ge concentration within a crystalline silicon germanium i-layer and the film thickness of the i-layer within each cell layer required to realize a short-circuit current of 11 mA/cm² for triple solar cells of an example 2 and a comparative example.

### Explanation of Reference:

- 1:: Substrate
- 2:: Transparent electrode layer
- 2a:: Ridge
- 2b:: Fine micro-texture
- 3:: Photovoltaic layer
- 4:: Back electrode layer
- 5a:: First intermediate contact layer
- 5b:: Second intermediate contact layer

- 6:: Solar cell module
- 7:: Substrate-side antireflection layer
- 8:: Back-side transparent electrode layer
- 91:: First cell layer
- 92:: Second cell layer
- 93:: Third cell layer
- 100:: Photovoltaic device

### Best Mode for Carrying Out the Invention

### First Embodiment

A description of a photovoltaic device according to a first embodiment of the present invention is presented below, using a tripe solar cell as an example.

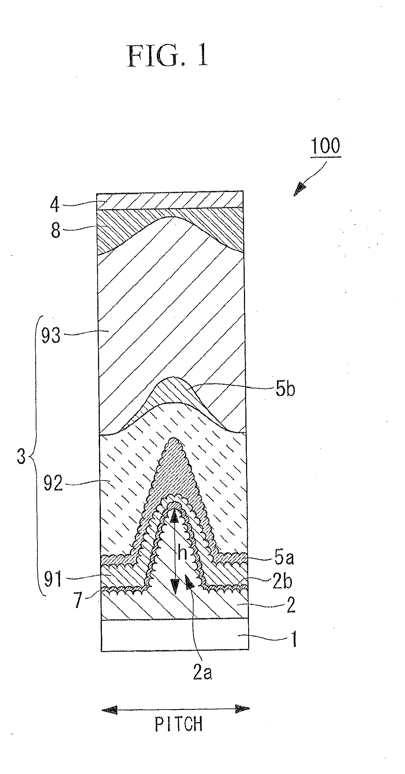

FIG. 1 is a schematic view illustrating the structure of a triple solar cell according to the first embodiment. A photovoltaic device 100 comprises a substrate 1, a transparent electrode layer 2, a first cell layer 91 (amorphous silicon-based), a second cell layer 92 (crystalline silicon-based) and a third cell layer 93 (crystalline silicon germanium-based) as a photovoltaic layer 3, and a back electrode layer 4. A substrate-side antireflection layer 7 is provided between the transparent electrode layer 2 and the first cell layer 91. A first intermediate contact layer 5a is provided between the first cell layer 91 and the second cell layer 92. A second intermediate contact layer 5b is provided between the second cell layer 92 and the third cell layer 93. A back-side transparent layer 8 is provided between the third cell layer 93 and the back electrode layer 4.
The term "crystalline silicon-based" describes a silicon system other than an amorphous silicon system, and includes both microcrystalline silicon and polycrystalline silicon.

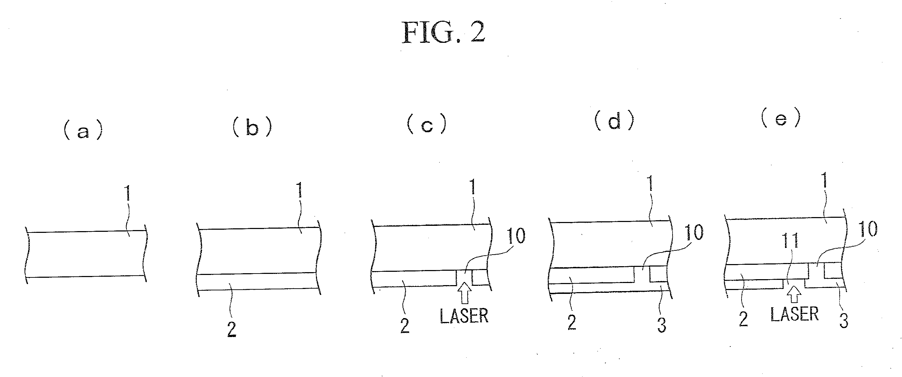

A description of a process for producing a photovoltaic device according to the first embodiment is presented below, using the production steps for a solar cell panel as an example. FIG. 2 to FIG. 5 are schematic views illustrating the process for producing a solar cell panel according to the present embodiment.

### (1) FIG. 2(a)

A soda float glass substrate (for example with dimensions of 1.4 m x 1.1 m x thickness: 3.5 to 4.5 mm) is used as the substrate 1. The edges of the substrate are preferably subjected to corner chamfering or R-face chamfering to prevent damage caused by thermal stress or impacts or the like.

### (2) FIG. 2(b)

A transparent electrode film comprising mainly tin oxide, such as a fluorine-doped tin oxide (SnO₂), and having a film thickness of approximately not less than 400 nm and not more than 800 nm is used as the transparent electrode layer 2. The transparent electrode layer 2 has a textured structure on the surface facing the photovoltaic layer 3, and this textured structure is composed of ridges 2a and a fine micro-texture 2b provided on the surface of the ridges 2a.

The pitch of the textured structure is represented by the width of the structure illustrated in FIG. 1, and corresponds with the repeating unit on the transparent electrode layer surface. In the present embodiment, the pitch of the textured structure is not less than 1.2 µm and not more than 1.6 µm.

The height of the ridges 2a (indicated by "h" in FIG. 1) is not less than 0.2 µm and not more than 0.8 µm.

The pitch of the fine micro-texture 2b corresponds with the width of a single wave. In the present embodiment, this pitch is not less than 0.05 µm and not more than 0.14 µm. The height of the fine micro-texture 2b is not less than 0.02 µm and not more than 0.1 µm.

The transparent electrode layer 2 can be formed using an ambient pressure CVD method, a vapor deposition method or a sputtering method or the like. In those cases where an ambient pressure CVD method is used to form the tin oxide film, the surface state of the transparent electrode layer can be controlled by appropriate adjustment of the deposition conditions such as the tin tetrachloride partial pressure, the water vapor partial pressure and the deposition temperature. Further, in those cases where the tin oxide film is formed using a sputtering method, the crystal grains can be formed at a desired density by altering the sputtering gas pressure and the deposition temperature. Accordingly, even if the tin oxide film is formed by sputtering, the surface state can still be controlled by appropriate adjustment of the deposition conditions.

In the formation of the transparent electrode layer having the textured structure described above, a nanoimprint method may be used to form a pattern having ridges of the desired shape on top of the substrate, and a tin oxide film may then be deposited on the surface of this pattern using a sputtering method. As described above, by appropriate setting of the sputtering conditions, a tin oxide film having a fine micro-texture of a desired shape can be deposited on the ridges. Alternatively, a nanoimprint method may be used to form a patterned resist film on the substrate, and a tin oxide film may then be deposited on the pattern using a sputtering method, before the resist is removed by etching, thereby removing the portions of the tin oxide film deposited on top of the resist. This enables the preparation of a pattern structure having a partially formed tin oxide film. Subsequently, by performing additional sputter deposition of a tin oxide film, the substrate can be coated with a tin oxide film having a textured structure of a predetermined shape.

In the present embodiment, an alkali barrier film (not shown in the figure) may be formed between the transparent electrode layer 2 and the substrate 1. The alkali barrier film is formed by using a thermal CVD apparatus at a temperature of approximately 500°C to deposit a silicon oxide film (SiO₂) having a film thickness of 50 nm to 150 nm.

In the first embodiment, the substrate-side antireflection layer 7 is provided between the transparent electrode layer 2 and the first cell layer 91. The existence of the substrate-side antireflection layer 7 suppresses light reflectance between the transparent electrode layer 2 and the first cell layer 91, thereby increasing the light transmitted into the first cell layer 91. The substrate-side antireflection layer 7 is composed of a material having a refractive index close to that of the first cell layer 91, such as a TiO₂ film, and has a film thickness of 0.02 µm to 0.06 µm. From an optical viewpoint, the thickness of the substrate-side antireflection layer 7 is preferably large, although if overly thick, the conductivity tends to deteriorate. The film thickness of the substrate-side antireflection layer 7 is set such that the short-circuit current, the open-circuit voltage, the form factor, and particularly the conversion efficiency for the solar cell are maximized.
The shape of the surface of the substrate-side antireflection layer 7 on the side of the photovoltaic layer has substantially the same textured structure as the transparent electrode layer 2, composed of ridges and a fine micro-texture provided on the surface of the ridges. The pitch of the fine micro-texture on the surface of the substrate-side antireflection layer 7 is not less than 0.05 µm and not more than 0.14 µm. Further, the height of the fine micro-texture on the surface of the substrate-side antireflection layer 7 is not less than 0.02 µm and not more than 0.1 µm.

### (3) FIG. 2(c)

Subsequently, the substrate 1 is mounted on an X-Y table, and the first harmonic of a YAG laser (1064 nm) is irradiated onto the surface of the transparent electrode film, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

### (4) FIG. 2(d)

Using a plasma enhanced CVD apparatus, a p-layer, an i-layer and an n-layer, each composed of a thin film of amorphous silicon, are deposited as the first cell layer 91. Using SiH₄ gas and H₂ gas as the main raw materials, and under conditions including a reduced pressure atmosphere of not less than 30 Pa and not more than 1,000 Pa and a substrate temperature of approximately 200°C, an amorphous silicon p-layer, an amorphous silicon i-layer and an amorphous silicon n-layer are deposited, in that order, on the transparent electrode layer 2, with the p-layer closest to the surface from which incident sunlight enters. The amorphous silicon p-layer comprises mainly amorphous B-doped silicon, and has a film thickness of not less than 10 nm and not more than 30 nm. The amorphous silicon i-layer has a film thickness of not less than 150 nm and not more than 350 nm. The amorphous silicon n-layer comprises mainly P-doped silicon in which microcrystalline silicon is incorporated within amorphous silicon, and has a film thickness of not less than 30 nm and not more than 50 nm. A buffer layer may be provided between the amorphous silicon p-layer and the amorphous silicon i-layer in order to improve the interface properties.

In the thus formed first cell layer 91, the surface that faces the first intermediate contact layer 5a has a surface shape in which a fine micro-texture is formed on the surface of a textured structure having ridges that are lower than the ridges within the transparent electrode layer. The fine micro-texture of the first cell layer 91 has a pitch of not less than 0.05 µm and not more than 0.18 µm, and a height of not less than 0 µm and not more than 0.1 µm.

The first intermediate contact layer 5a, which functions as a semi-reflective film for improving the contact properties and achieving electrical current consistency, is provided between the first cell layer 91 and the second cell layer 92. The first intermediate contact layer 5a completely covers the first cell layer 91. The average film thickness of the first intermediate contact layer 5a is not less than 0.03 µm and not more than 0.09 µm.
The surface of the first intermediate contact layer 5a that faces the second cell layer 92 has a textured structure that can be represented, for example, by a sine curve, and the ridges within this textured structure are higher than the ridges of the transparent electrode layer. In the first embodiment, the maximum height of the first intermediate contact layer 5a on the side of the second cell layer 92 is defined as the difference obtained by subtracting the height of the ridges within the underlying transparent electrode layer from the distance between a ridge and a valley within the textured structure of the first intermediate contact layer 5a, or in other words, twice the maximum deviation (amplitude) from the center of the sine curve wave. The center of the sine curve wave is located at a position higher than the surface of the immediately underlying first cell layer by an amount equal to the average film thickness of the first intermediate contact layer 5a. Further, if the sine curve reaches a position lower than the surface of the first cell layer, then the first cell layer is exposed at that position.
The maximum height of the first intermediate contact layer 5a in the first embodiment is not less than 0 µm and not more than 0.42 µm. A fine micro-texture is formed on the surface of the first intermediate contact layer 5a that faces the second cell layer 92. The pitch of this fine micro-texture is not less than 0.05 µm and not more than 0.2 µm, and the height is not less than 0 µm and not more than 0.08 µm.

A GZO (Ga-doped ZnO) film is deposited as the first intermediate contact layer 5a by using a sputtering apparatus with a Ga-doped ZnO sintered body as the target. The surface shape of the first intermediate contact layer 5a on the side of the second cell layer can be controlled by altering the settings for the deposition conditions such as the sputter gas pressure and the deposition temperature.
By using inclined sputtering, in which the deposition is conducted with the substrate inclined from a position parallel to the target, the GZO film of the first intermediate contact layer can be formed solely on the ridges of the first cell layer surface.
Further, a nanoimprint method may be used to apply a patterned resist onto the first cell layer, and then following deposition of the GZO film, the resist may be subjected to etching. This removes only those portions of the GZO film deposited on top of the resist, thereby forming a patterned structure in which the GZO film is deposited only on the ridges of the first cell layer. Subsequently, an additional GZO film is deposited uniformly across the entire patterned structure. This process enables a first intermediate contact layer of predetermined shape to be formed in a manner that completely covers the first cell layer 91.

Using a plasma enhanced CVD apparatus, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer, a crystalline silicon i-layer and a crystalline silicon n-layer are deposited, in that order, as the second cell layer 92 on top of the first intermediate contact layer 5a. The crystalline silicon p-layer comprises mainly B-doped microcrystalline silicon, and has a film thickness of not less than 10 nm and not more than 50 nm. The crystalline silicon i-layer comprises mainly microcrystalline silicon, and has a film thickness of not less than 1.0 µm and not more than 3.0 µm. The crystalline silicon n-layer comprises mainly P-doped microcrystalline silicon, and has a film thickness of not less than 20 nm and not more than 50 nm. The surface of the second cell layer 92 that faces the second intermediate contact layer 5b has a textured shape with a more gentle incline than the surface shape of the first intermediate contact layer 5a.

During formation of the i-layer film comprising mainly microcrystalline silicon using a plasma enhanced CVD method, a distance d between the plasma discharge electrode and the surface of the substrate 1 is preferably not less than 3 mm and not more than 10 mm. If this distance d is less than 3 mm, then the precision of the various structural components within the film deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

Using a sputtering method, a GZO film is provided between the second cell layer 92 and the third cell layer 93 as the second intermediate contact layer 5b.
As illustrated in FIG. 1, the second intermediate contact layer 5b partially covers the second cell layer 92. The surface of the second intermediate contact layer 5b that faces the third cell layer 93 is, for example, a hat-like shape that can be represented by a sine curve. When the sine curve of the second intermediate contact layer 5b exists above the surface of the second cell layer 92, the second cell layer is partially covered by the second intermediate contact layer, meaning a portion of the second cell layer is exposed. If the surface area of this exposed portion within the substrate plane is specified as an aperture ratio, then the aperture ratio is approximately 40%. This type of second intermediate contact layer that partially covers the second cell layer can be formed, for example, by an inclined sputtering method.

When the textured structure on the surface of the second intermediate contact layer 5b that faces the third cell layer 93 is represented by a sine function, the height of the textured structure (the distance between a ridge and a valley, or in other words, twice the amplitude of the sine curve) is not less than 0.22 µm and not more than 0.7 µm. Once deposition is completed through to the second cell layer, the surface shape of the transparent electrode layer has no effect on the surface of the second cell layer, and therefore in the first embodiment, the height of the textured structure on the surface of the second intermediate contact layer 5b that faces the third cell layer 93 coincides with the maximum height of the second intermediate contact layer. Furthermore, the average film thickness of the second intermediate contact layer 5b that includes the open portions is determined by calculating the average under the assumption that the second intermediate contact layer also exists within the open portions. In the present embodiment, the average film thickness of the second intermediate contact layer 5b is not less than 0.03 µm and not more than 0.09 µm.
The center of the sine curve wave is located at a position higher than the surface of the immediately underlying second cell layer by an amount equal to the average film thickness of the second intermediate contact layer 5b. Further, if the sine curve reaches a position lower than the surface of the second cell layer, then the second cell layer is exposed at that position.

Using a plasma enhanced CVD apparatus, a p-layer composed of a thin film of crystalline silicon, an i-layer composed of a thin film of crystalline silicon germanium, and an n-layer composed of a thin film of crystalline silicon are deposited as the second cell layer 93 on top of the second intermediate contact layer 5b. SiH₄ gas, GeH₄ gas and H₂ gas are used as the main raw materials, and the p-layer, i-layer and n-layer are deposited, in that order, under conditions including a reduced pressure atmosphere of not more than 3,000 Pa, a substrate temperature of approximately 200°C and a plasma generation frequency of not less than 40 MHz and not more than 100 MHz. The GeH₄ gas is not used during deposition of the p-layer and n-layer. The ratio within the crystalline silicon germanium i-layer of the number of germanium atoms relative to the combined total of germanium atoms and silicon atoms (hereafter this ratio is referred to as the "Ge composition ratio") can be controlled by adjusting proportion of flow rates of gasses as the raw materials. The Ge composition ratio is preferably set to a value of not less than 10 atomic% and not more than 35 atomic%. The crystalline silicon p-layer is a boron-doped crystalline silicon film, and has a film thickness of not less than 10 nm and not more than 50 nm. The thickness of the crystalline silicon germanium i-layer is not less than 1.0 µm and not more than 4.0 µm. The crystalline silicon n-layer is a phosphorus-doped crystalline silicon film, and has a film thickness of not less than 10 nm and not more than 50 nm.
The surface of the third cell layer 93 on the side of the back-side transparent layer 8 has a more gentle incline than the surface of the second intermediate contact layer.

### (5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1, and in this case, because the high vapor pressure generated by the energy absorbed by the amorphous silicon-based first cell layer of the photovoltaic layer 3 can be utilized in etching the photovoltaic layer 3, more stable laser etching processing can be performed. The position of the laser etching line is determined with due consideration of positioning tolerances, so as not to overlap with the previously formed etching line.

Using a sputtering method, a GZO film is provided on the third cell layer 93 as the back-side transparent layer 8, for the purposes of reducing the contact resistance and improving the light reflectance. The average film thickness of the back-side transparent layer 8 is not less than 0.23 µm and not more than 0.36 µm. The surface of the back-side transparent layer 8 that faces the back electrode layer 4 is flat. This is because by forming the back-side transparent layer as a thick film, the effect of the textured shape of the underlying layer can be reduced. Further, a chemical mechanical polishing (CMP) method may be used to etch the surface of the back-side transparent layer in order to flatten the surface.
Furthermore, following deposition of the GZO film, a transparent layer with a lower refractive index than the GZO film (such as a SiO₂ film) may also be deposited as part of the back-side transparent layer 8. This enables the reflectance at the back side of the device to be further improved, thereby increasing the amount of light reflected back onto the photovoltaic layer.

### (6) FIG. 3(a)

Using a sputtering apparatus, an Ag film and a Ti film are deposited sequentially as the back electrode layer 4 under a reduced pressure atmosphere and at a deposition temperature of 150°C to 200°C. In this embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of a Ag film having a thickness of 25 nm to 100 nm, and an Al film having a thickness of 15 nm to 500 nm.

### (7) FIG. 3(b)

The substrate 1 is mounted on an X-Y table, and the second harmonic of a laser diode excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) FIG. 3(c) and FIG. 4(a)

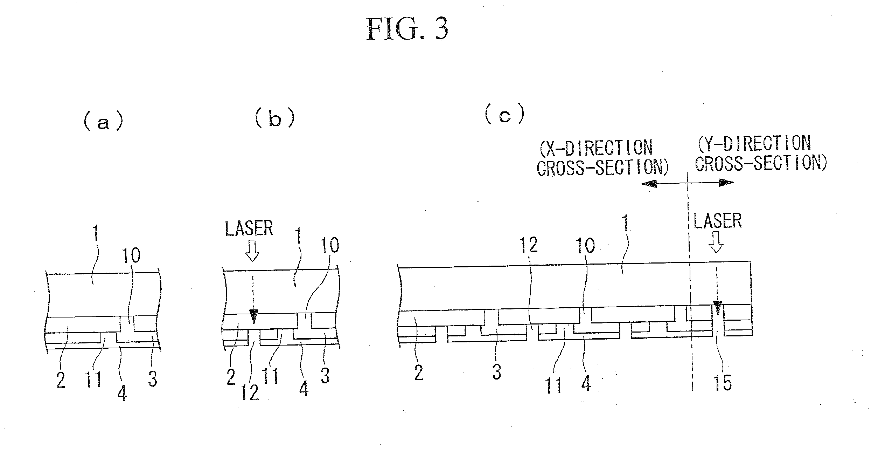

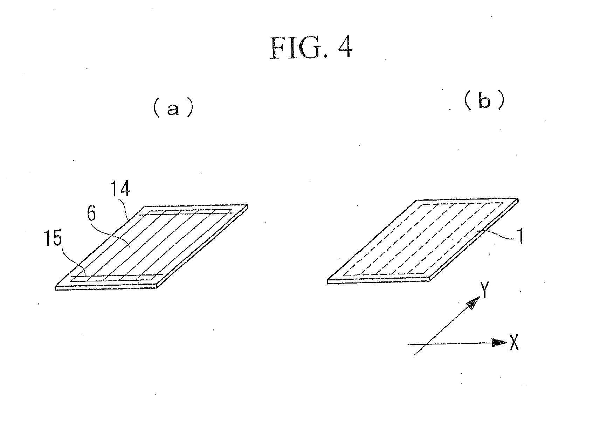

Peripheral film removal processing is then performed to prevent short circuits within the laser etched portions near the edges of the substrate. The substrate 1 is mounted on an X-Y table, and the second harmonic of a laser diode excited YAG laser (532 nm) is irradiated through the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). FIG. 3(c) represents an X-direction cross-sectional view cut along the direction of the series connection of the photovoltaic layer 3, and therefore the location in the figure where the insulation slot 15 is formed should actually appear as a peripheral film removed region 14 in which the back electrode layer 4, the photovoltaic layer 3 and the transparent electrode layer 2 have been removed by film polishing (see FIG. 4(a)), but in order to facilitate description of the processing of the edges of the substrate 1, this location in the figure represents a Y-direction cross-sectional view, so that the formed insulation slot represents an X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YV04 laser or fiber laser or the like may also be used in a similar manner.

### (9) FIG. 4 (a: view from solar cell film surface side, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film removed region 14. During removal of the films from a region that is 5 mm to 20 mm from the edge around the entire periphery of the substrate 1, grinding or blast polishing or the like is used to remove the back electrode layer 4, the photovoltaic layer 3 and the transparent electrode layer 2 from a region that is closer to the substrate edge in the X direction than the insulation slot 15 provided in the above step of FIG. 3(c), and closer to the substrate edge in the Y direction than the slot 10 provided near the substrate edge.
Grinding debris or abrasive grains are removed by washing the substrate 1.

### (10) FIG. 5(a) (b)

An attachment portion for a terminal box 23 is prepared by providing an open through-window in the backing sheet 24 to expose a collecting plate. A plurality of layers of an insulating material are provided in this open through-window portion in order to prevent external moisture and the like entering the solar cell module.
Processing is conducted so as to enable current collection, using a copper foil, from the series-connected solar cell electric power generation cell at one end, and the solar cell electric power generation cell at the other end, in order to enable electric power to be extracted from the terminal box 23 on the rear surface of the solar cell panel. In order to prevent short circuits between the copper foil and the various portions, an insulating sheet that is wider than the width of the copper foil is provided.
Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.
A backing sheet 24 with a superior waterproofing effect is then positioned on top of the EVA. In this embodiment, in order to achieve a superior waterproofing and moisture-proofing effect, the backing sheet 24 is formed as a three-layer structure comprising a PET sheet, an Al foil and a PET sheet.
The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

### (11) FIG. 5(a)

The terminal box 23 is attached to the back of the solar cell module 6 using an adhesive.

### (12) FIG. 5(b)

The copper foil and an output cable from the terminal box 23 are connected using solder or the like, and the interior of the terminal box 23 is filled and sealed with a sealant (a potting material). This completes the production of the solar cell panel 50.

### (13) FIG. 5(c)

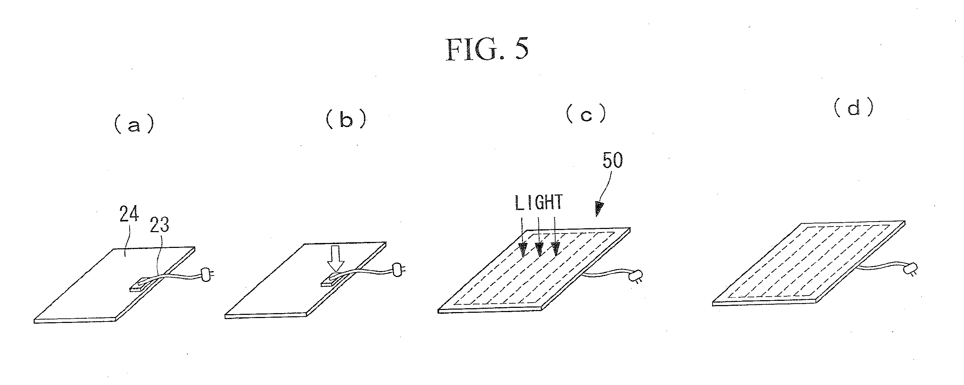

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).

### (14) FIG. 5(d)

In tandem with the electric power generation test (FIG. 5(c)), a variety of specific performance factors including the external appearance are evaluated.

An optical analysis calculation for a triple solar cell of the structural model illustrated in FIG. 1 for the case where incident light enters the solar cell from the side of the glass substrate was conducted using a FDTD (Finite Difference Time Domain) method. The composition and film thickness of each layer shown in FIG. 1 were set as follows.
Transparent electrode layer (F-doped SnO₂ film): 460 nm
Substrate-side antireflection layer (TiO₂ film): 0.04 µm
First cell layer
   Amorphous silicon p-layer: 10 nm
   Amorphous silicon i-layer: 200 nm
   Crystalline silicon n-layer: 40 nm
Second cell layer
   Crystalline silicon p-layer: 30 nm
   Crystalline silicon i-layer: 1.7 µm
   Crystalline silicon n-layer: 30 nm
Third cell layer
   Crystalline silicon p-layer: 30 nm
   Crystalline silicon germanium i-layer: 1.5 µm, Ge concentration: 20%
   Crystalline silicon n-layer: 30 nm
Second intermediate contact layer aperture ratio: 40%
Back-side transparent layer (GZO film / SiO₂ film), SiO₂ film: 0.02 µm

### Back electrode layer (Ag film): 160 nm

In each of the analyses, with the exception of the variable numerical value, each of the remaining surface shapes and film thickness values were set to the representative values listed below for the calculations.
Transparent electrode layer - textured structure pitch: 1.5 µm
Transparent electrode layer - height of ridges: 0.8 µm
Transparent electrode layer - proportion of 1 pitch of the textured structure represented by ridge: 35%
Transparent electrode - fine micro-texture pitch: 0.1 µm, height: 0.1 µm
Fine micro-texture on the surface of the substrate-side antireflection layer that faces the first cell layer - pitch: 0.1 µm, height: 0.1 µm
Fine micro-texture on the surface of the first cell layer that faces the first intermediate contact layer - pitch: 0.1 µm, height: 0.1 µm
First intermediate contact layer (GZO film) - average film thickness: 0.08 µm
First intermediate contact layer - maximum height: 0.42 µm
Fine micro-texture on the surface of the first intermediate contact layer that faces the second cell layer - pitch: 0.05 µm, height: 0.08 µm
Second intermediate contact layer (GZO film) - average film thickness: 0.03 µm, height of textured structure: 0.7 µm
Back-side transparent layer - GZO film thickness: 0.23 µm
The height of the textured structure on the surface of the first intermediate contact layer that faces the second cell layer was the sum of the maximum height of the GZO film mentioned above and the height of the ridges of the transparent electrode layer.

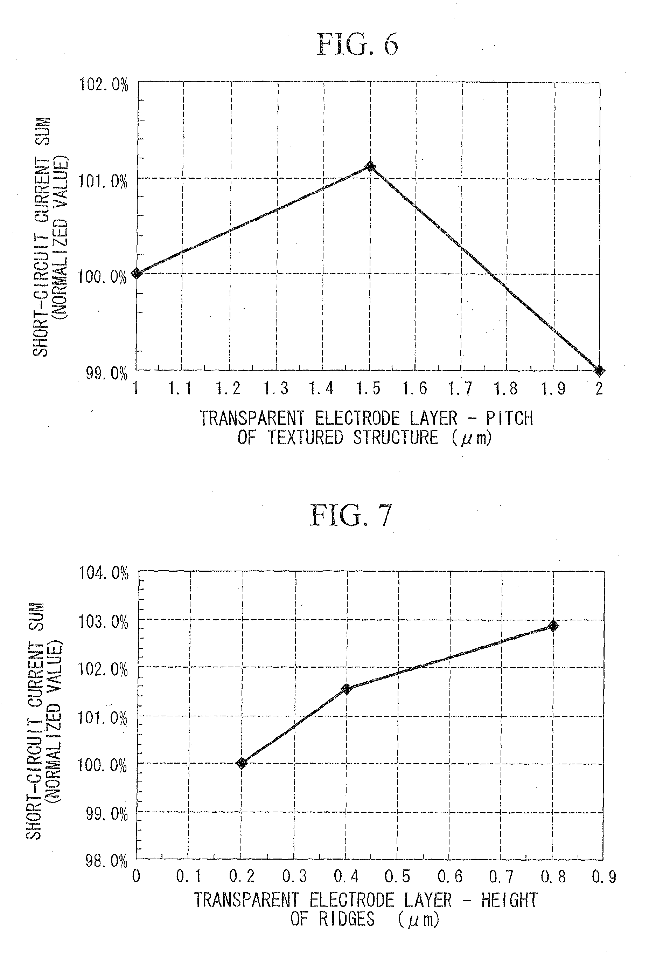

FIG. 6 through FIG. 20 are graphs illustrating the effects that the surface shape and film thickness of each layer within the triple solar cell have upon the cell short-circuit current. In each figure, the vertical axis represents the sum of the short-circuit currents generated in the first cell layer through to the third cell layer. If the optical analysis calculations yield a difference in the electrical current value of at least 0.33%, then it can be claimed that an advantageous difference should also be obtained for an actual produced solar cell.

As illustrated in FIG. 6, an increase in the short-circuit current is observed when the pitch of the textured structure is within a range from not less than 1.2 µm to not more than 1.6 µm, and particularly when the pitch is not less than 1.3 µm and not more than 1.5 µm.

As illustrated in FIG. 7, an increase in the short-circuit current is observed when the height of the ridges of the transparent electrode layer is within a range from not less than 0.2 µm to not more than 0.8 µm, and particularly when the ridge height is not less than 0.3 µm and not more than 0.8 µm.

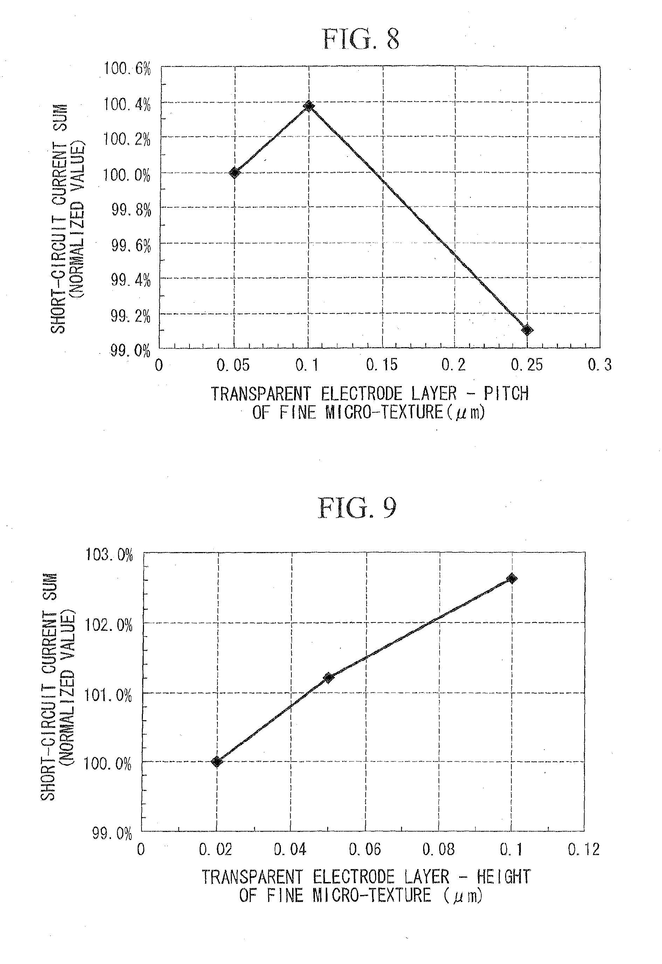

As illustrated in FIG. 8, the short-circuit current increases when the pitch of the fine micro-texture on the transparent electrode layer is not less than 0.05 µm and not more than 0.14 µm. Further, as illustrated in FIG. 9, the short-circuit current increases when the height of the fine micro-texture on the transparent electrode layer is within a range from not less than 0.02 µm to not more than 0.1 µm. The short-circuit current can be increased further by setting the fine micro-texture height to not less than 0.03 µm and not more than 0.1 µm.

In this manner, by optimizing the shape of the surface of the transparent electrode layer on the side of the photovoltaic layer so as to satisfy the above ranges, the short-circuit current of the triple solar cell can be increased. As a result, the output from the solar cell can be increased.

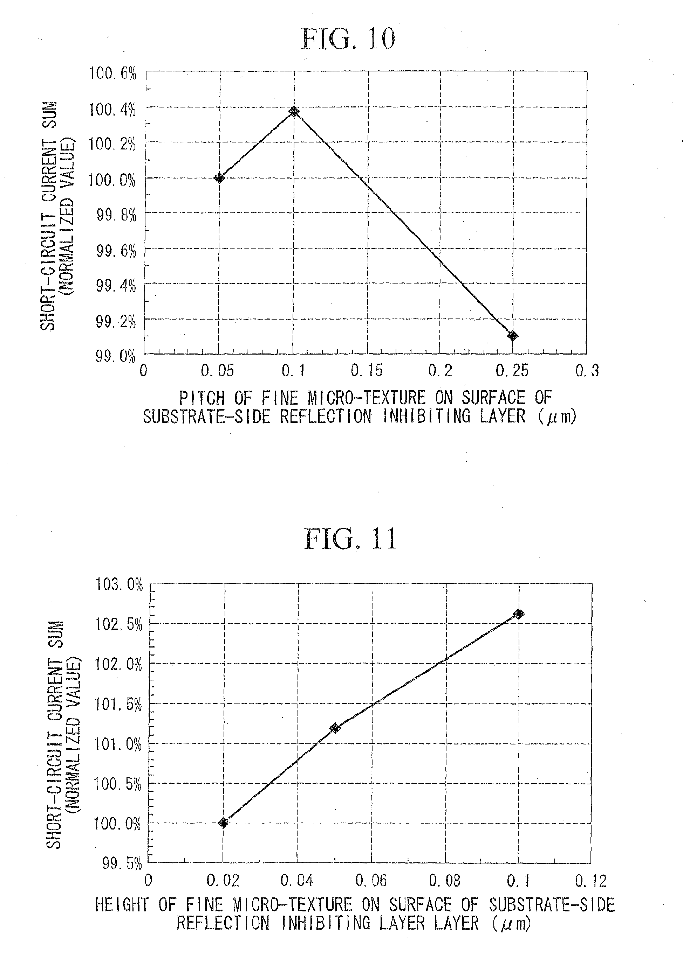

As illustrated in FIG. 10 and FIG. 11, by optimizing the surface shape of the substrate-side antireflection layer on the side of the first cell layer, the short-circuit current of the triple solar cell can be increased. Setting the pitch of the fine micro-texture on the surface of the substrate-side antireflection layer that faces the first cell layer to not less than 0.05 µm and not more than 0.14 µm, and particularly to not less than 0.09 µm and not more than 0.11 µm, increases the short-circuit current. The height of the fine micro-texture on the surface of the substrate-side antireflection layer that faces the first cell layer has a large effect on the cell short-circuit current. By setting the height of the fine micro-texture on the surface of the substrate-side antireflection layer that faces the first cell layer to not less than 0.02 µm and not more than 0.1 µm, preferably to not less than 0.03 µm and not more than 0.1 µm, and particularly to not less than 0.05 µm and not more than 0.1 µm, the cell short-circuit current can be increased significantly.

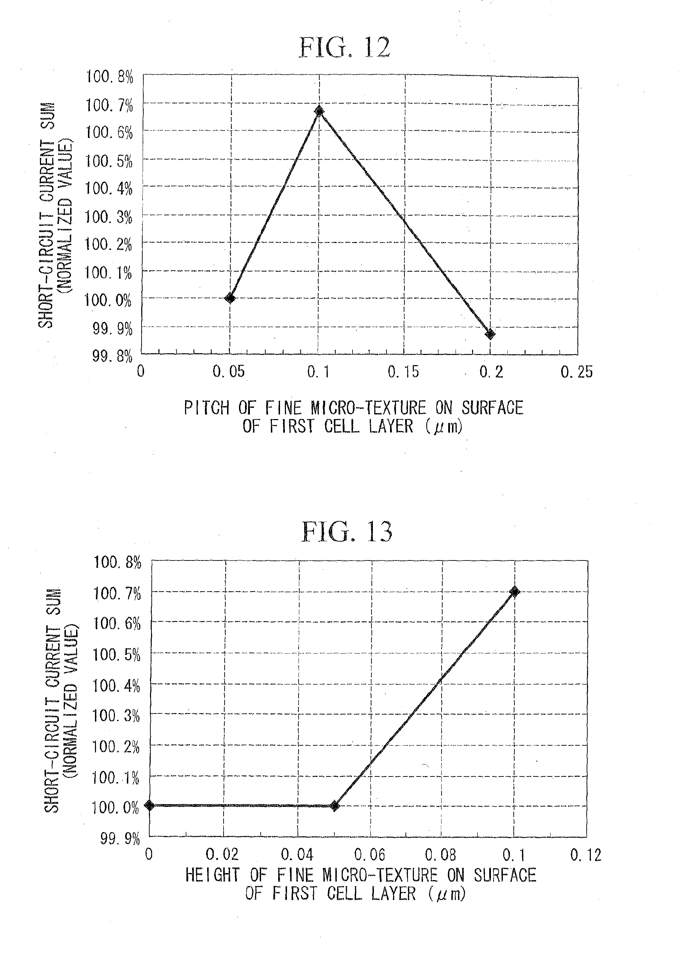

As illustrated in FIG. 12 and FIG. 13, by optimizing the surface shape of the first cell layer on the side of the first intermediate contact layer, the short-circuit current of the triple solar cell can be increased. By adjusting the fine micro-texture on the surface of the first cell layer that faces the first intermediate contact layer so that the pitch is not less than 0.05 µm and not more than 0.18 µm, and preferably not less than 0.07 µm and not more than 0.15 µm, and the height is not less than 0 µm and not more than 0.1 µm, and preferably not less than 0.07 µm and not more than 0.1 µm, the cell short-circuit current can be increased.

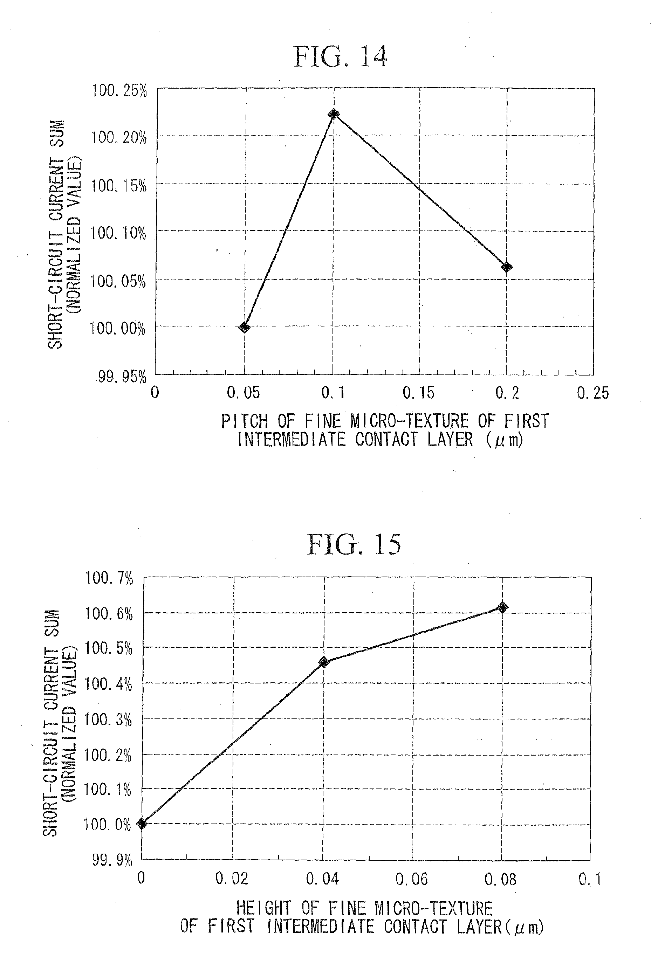

As illustrated in FIG. 14 and FIG. 15, by adjusting the fine micro-texture on the surface of the first intermediate contact layer on the side of the second cell layer so that the pitch is not less than 0.05 µm and not more than 0.2 µm, and the height is not less than 0 µm and not more than 0.08 µm, and preferably not less than 0.03 µm and not more than 0.08 µm, the cell short-circuit current can be increased. The effect that the fine micro-texture on the surface of the first intermediate contact layer has on the cell short-circuit current is somewhat less than the effect observed for other factors.

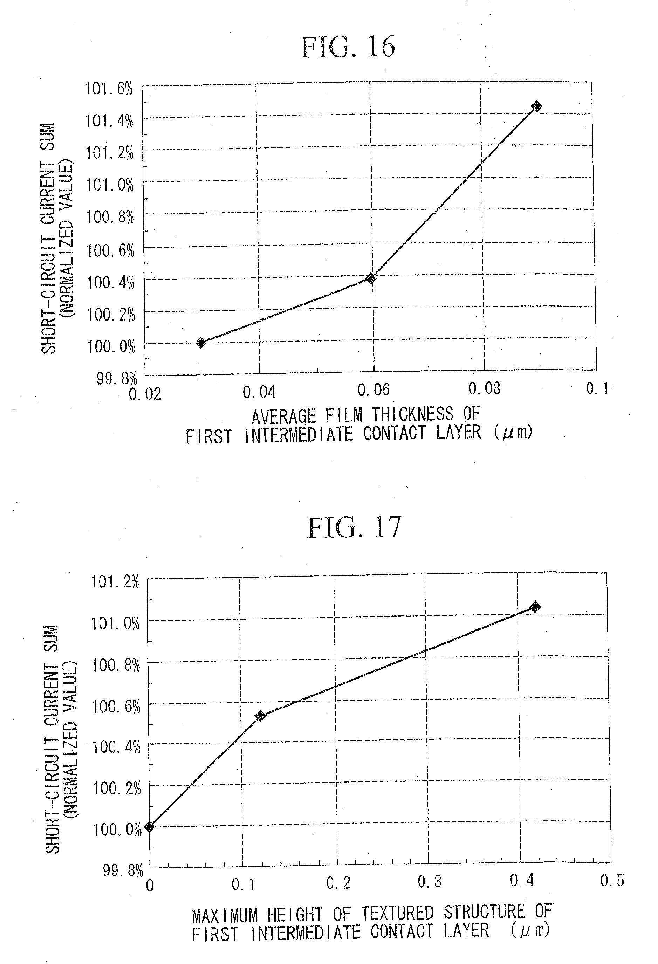

As illustrated in FIG. 16, by setting the average film thickness of the first intermediate contact layer to not less than 0.03 µm and not more than 0.09 µm, and preferably not less than 0.05 µm and not more than 0.09 µm, the short-circuit current can be increased. Further, as illustrated in FIG. 17, by setting the maximum height of the first intermediate contact layer to not less than 0 µm and not more than 0.42 µm, and preferably not less than 0.08 µm and not more than 0.42 µm, the short-circuit current can be increased.

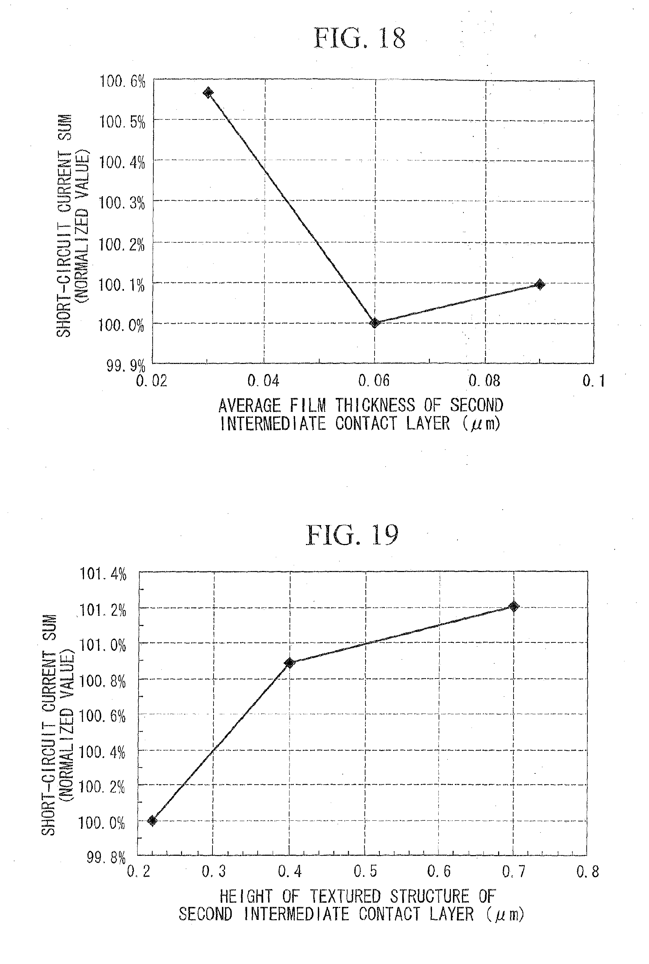

The average film thickness of the second intermediate contact layer is preferably within a range from not less than 0.03 µm to not more than 0.09 µm. However, as is evident from FIG. 18, the effect that the average film thickness has on the short-circuit current of a solar cell of the first embodiment is quite small.

As illustrated in FIG. 19, by setting the height of the textured structure of the second intermediate contact layer to not less than 0.22 µm and not more than 0.7 µm, and preferably not less than 0.3 µm and not more than 0.7 µm, the short-circuit current can be increased.

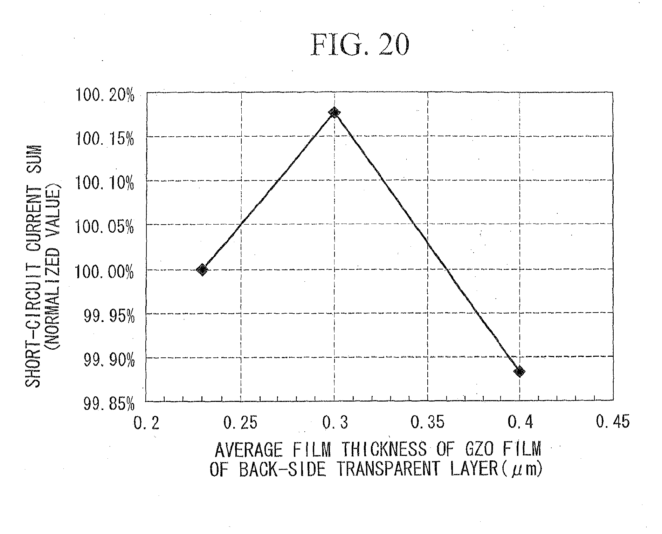

As illustrated in FIG. 20, the film thickness of the GZO film of the back-side transparent layer also contributes to an improvement in the short-circuit current of the solar cell. By setting the GZO film thickness of the back-side transparent layer to not less than 0.23 µm and not more than 0.36 µm, the short-circuit current can be increased.

### Second Embodiment

A photovoltaic device according to the second embodiment is described below using a triple solar cell as an example.

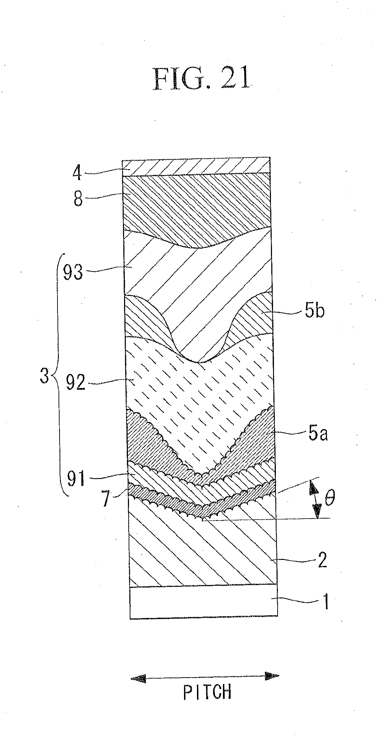

FIG. 21 is a schematic view illustrating the structure of a triple solar cell according to the second embodiment. The layer configuration and the composition of each layer are the same as those described for the solar cell of the first embodiment.

In the solar cell of the second embodiment, the surface of the transparent electrode layer 2 on the side of the substrate-side antireflection layer 7 has a V-shaped textured structure. The pitch of the textured structure is represented by the width of the structure illustrated in FIG. 21, and corresponds with the repeating unit of the V-shape. In the present embodiment, the pitch of the textured structure is not less than 0.3 µm and not more than 5 µm. If the angle of the V-shape relative to the substrate surface is termed the inclination angle •, then this inclination angle • is set to not less than 15° and not more than 60°.

The transparent electrode layer (tin oxide film) having the surface shape described above is formed by an ambient pressure CVD method or the like. When an ambient pressure CVD method is used, the surface shape can be controlled by appropriate setting of the deposition conditions such as the tin tetrachloride partial pressure, the water vapor partial pressure and the deposition temperature.

The substrate-side antireflection layer 7 (for example, a TiO₂ film) of the second embodiment has a film thickness of 0.002 µm to 0.06 µm. The surface of the substrate-side antireflection layer 7 on the side of the first cell layer 91 has a surface shape that follows the shape of the transparent electrode layer 2, with a fine micro-texture formed on the surface of a larger textured structure. The fine micro-texture may be eliminated in some cases. The shape of the fine micro-texture is the same as that described for the first embodiment.

In the second embodiment, the surface of the first cell layer 91 on the side of the first intermediate contact layer 5a has a surface shape in which a fine micro-texture is formed on the surface of a larger textured structure that has a more gentle inclination than that of the substrate-side antireflection layer 7. The shape of the fine micro-texture on the first cell layer 91 is the same as that described for the first embodiment.

In the second embodiment, the surface of the first intermediate contact layer 5a on the side of the second cell layer 92 has a surface shape in which a fine micro-texture is formed on the surface of a larger textured structure that is represented, for example, by a sine curve.
In those cases where the textured structure on the surface of the first intermediate contact layer 5a that faces the second cell layer 92 is represented by a sine curve, the height of the textured structure is not less than 0.22 µm and not more than 0.64 µm. Further, the average film thickness of the first intermediate contact layer 5a is not less than 0.03 µm and not more than 0.09 µm. The shape of the fine micro-texture of the first intermediate contact layer 5a of the second embodiment is the same as that described for the first embodiment. In the second embodiment, the height of the textured structure on the surface of the first intermediate contact layer 5a on the side the second cell layer 92 coincides with the maximum height of the first intermediate contact layer 5a.

In the second embodiment, the surface of the second intermediate contact layer 5b on the side of the third cell layer 93 has a large textured structure that is represented, for example, by a sine curve. In the second embodiment, the aperture ratio of the second intermediate contact layer 5b is 40%.
In those cases where the textured structure of the second intermediate contact layer 5b is represented by a sine curve, the height of the textured structure is not less than 0.22 µm and not more than 0.64 µm. Further, the average film thickness of the second intermediate contact layer 5b is not less than 0.03 µm and not more than 0.09 µm. In the second embodiment, the height of the textured structure on the surface of the second intermediate contact layer 5b on the side the third cell layer 93 coincides with the maximum height of the second intermediate contact layer 5b.

In the second embodiment, the surface of the GZO film of the back-side transparent layer 8 on the side of the back electrode layer is flat. The average film thickness of the back-side transparent layer 8 is not less than 0.23 µm and not more than 0.4 µm.

An optical analysis calculation was conducted for a triple solar cell of the structural model illustrated in FIG. 21 for the case where incident light enters the solar cell from the side of the glass substrate. For each of the layers shown in FIG. 21, the structures and film thickness values were the same as the first embodiment, with the exceptions of setting the film thickness of the transparent electrode layer to 700 nm, the film thickness of the substrate-side antireflection layer to 0.06 µm, the thickness of the amorphous silicon i-layer of the first cell layer to 200 nm, the thickness of the crystalline silicon i-layer of the second cell layer to 1.6 µm, the thickness of the crystalline silicon germanium i-layer of the third cell layer to 1.6 µm, the Ge concentration to 20%, and the aperture ratio of the second intermediate contact layer to 40%.

In each of the analyses, with the exception of the numerically varied surface shape factor, each of the remaining surface shapes and film thickness values were set to the representative values listed below for the calculations.
Transparent electrode layer pitch: 1 µm
Transparent electrode layer inclination angle: 30°
Fine micro-texture on the surface of the substrate-side antireflection layer that faces the first cell layer - pitch: 0.1 µm, height: 0.1 µm
Fine micro-texture on the surface of the first cell layer that faces the first intermediate contact layer - pitch: 0.1 µm, height: 0.1 µm
First intermediate contact layer (GZO film) - average film thickness: 0.03 µm, height of textured structure: 0.7 µm
Fine micro-texture on the surface of the first intermediate contact layer that faces the second cell layer - pitch: 0.05 µm, height: 0.08 µm
Second intermediate contact layer (GZO film) - average film thickness: 0.06 µm, height of textured structure: 0.64 µm
Back-side transparent layer - GZO film thickness: 0.4 µm

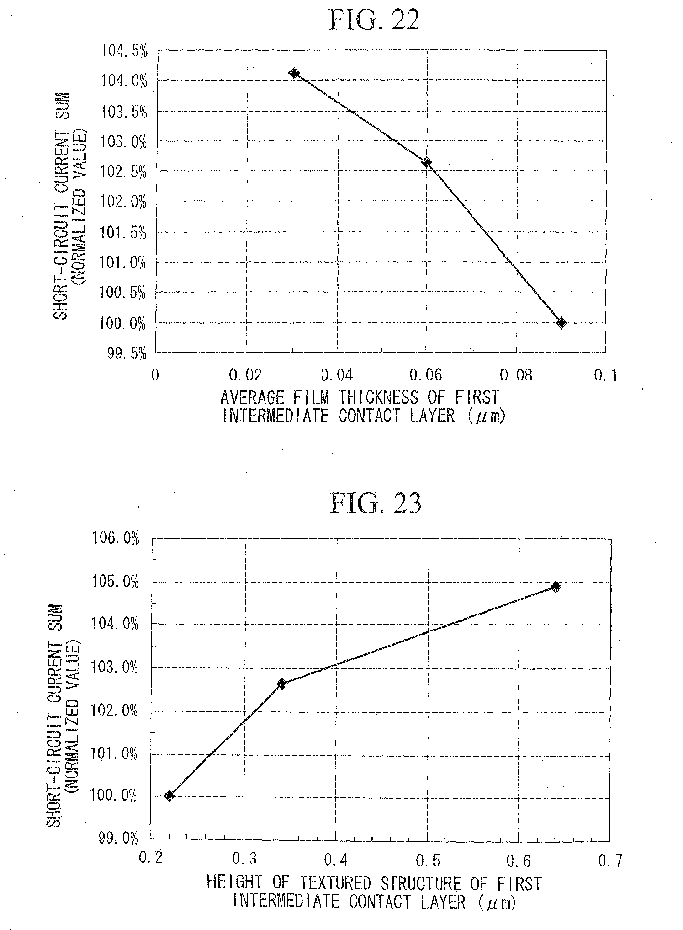

FIG. 22 through FIG. 26 are graphs illustrating the effects that the surface shape and film thickness of each layer within the triple solar cell have upon the cell short-circuit current. In each figure, the vertical axis represents the sum of the short-circuit currents generated in the first cell layer through to the third cell layer. For the fine micro-texture on the surface of the first cell layer that faces the first intermediate contact layer, the fine micro-texture on the surface of the first intermediate contact layer that faces the second cell layer, and the fine micro-texture on the surface of the second intermediate contact layer that faces the third cell layer, the same trends as those of the first embodiment were observed.

FIG. 22 illustrates the effect the average film thickness of the first intermediate contact layer has on the cell short-circuit current. As the average film thickness of the first intermediate contact layer increases, the short-circuit current decreases. By setting the average film thickness of the first intermediate contact layer to a value of not less than 0.03 µm and not more than 0.09 µm, and preferably not less than 0.03 µm and not more than 0.08 µm, a solar cell having a high short-circuit current can be obtained.

As illustrated in FIG. 23, the height of the textured structure of the first intermediate contact layer has a large contribution in increasing the short-circuit current of a solar cell according to the second embodiment. By setting the height of the textured structure of the first intermediate contact layer to not less than 0.22 µm and not more than 0.64 µm, and preferably not less than 0.25 µm and not more than 0.64 µm, the short-circuit current can be increased significantly.

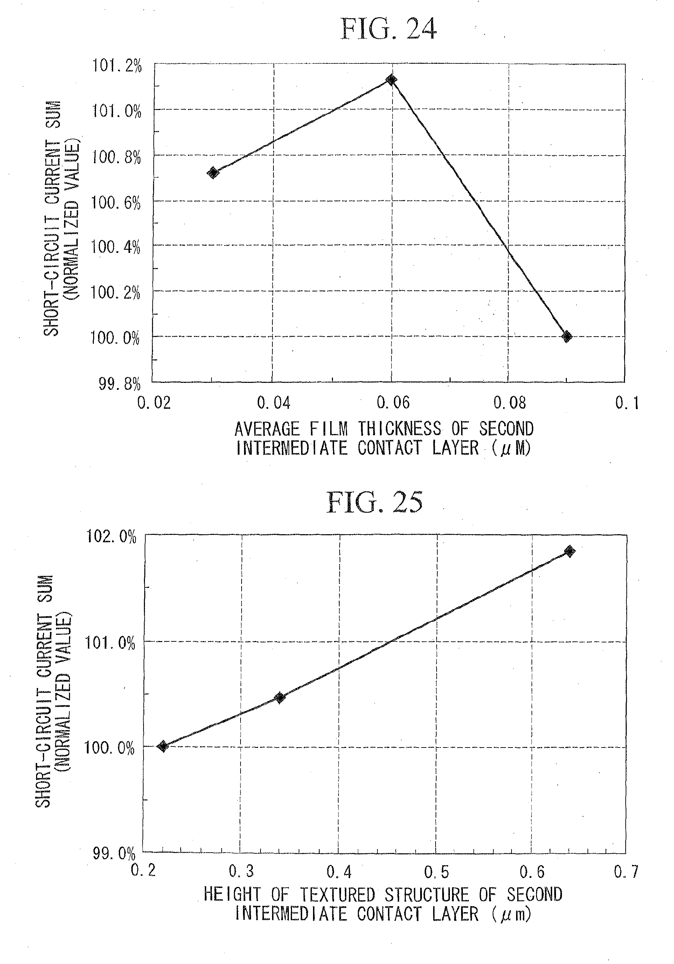

As illustrated in FIG. 24, by setting the average film thickness of the second intermediate contact layer to not less than 0.03 µm and not more than 0.09 µm, and preferably not less than 0.03 µm and not more than 0.08 µm, a solar cell having a high short-circuit current can be obtained.

As illustrated in FIG. 25, the height of the textured structure of the second intermediate contact layer contributes to the increase in the short-circuit current of a solar cell according to the second embodiment. By setting the height of the textured structure of the second intermediate contact layer to not less than 0.22 µm and not more than 0.64 µm, and preferably not less than 0.25 µm and not more than 0.64 µm, the short-circuit current can be increased significantly.

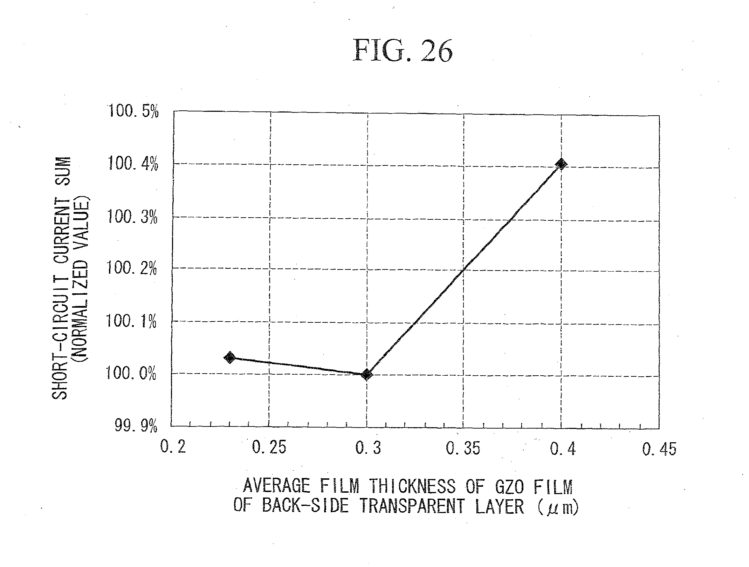

FIG. 26 illustrates the effect that the thickness of the GZO film of the back-side transparent layer has on the cell short-circuit current. By setting the GZO film thickness of the back-side transparent layer to not less than 0.23 µm and not more than 0.4 µm, and preferably not less than 0.38 µm and not more than 0.4 µm, the short-circuit current can be increased.

Although the above embodiments described a triple solar cell as an example of the photovoltaic device, the present invention is not restricted to this example, and for example, can be similarly applied to single solar cells or tandem solar cells containing a crystalline silicon-germanium i-layer.

### Examples

### Example 1

For a triple solar cell of the structural model illustrated in FIG. 1, the composition and film thickness of each layer were set as follows.
Transparent electrode layer (F-doped SnO₂ film): 460 nm Substrate-side antireflection layer (TiO₂ film): 0.04 µm
First cell layer
   Amorphous silicon p-layer: 10 nm
   Crystalline silicon n-layer: 40 nm
Second cell layer
   Crystalline silicon p-layer: 30 nm
   Crystalline silicon n-layer: 30 nm
Third cell layer
   Crystalline silicon p-layer: 30 nm
   Crystalline silicon n-layer: 30 nm
First intermediate contact layer (GZO film): 0.08 µm (average film thickness)
Second intermediate contact layer (GZO film): 0.03 µm (average film thickness), aperture ratio: 40%
Back-side transparent layer
GZO film: 0.23 µm
SiO₂ film: 0.02 µm
Back electrode layer (Ag film): 160 nm
The surface shape of each layer was set using the surface shape representative values described above for the first embodiment.

The film thickness for the i-layer of each cell layer required to achieve a cell short-circuit current of 11 mA/cm² when the Ge concentration of the silicon germanium i-layer of the third cell layer was set to a value within a range from 10% to 35% was measured by optical analysis using a FDTD method.

### Example 2

For a triple solar cell of the structural model illustrated in FIG. 21, the composition and film thickness of each layer were set as follows.
Transparent electrode layer (F-doped SnO₂ film): 700 nm Substrate-side antireflection layer (TiO₂ film): 0.06 µm
First cell layer
   Amorphous silicon p-layer: 10 nm
   Crystalline silicon n-layer: 40 nm
Second cell layer
   Crystalline silicon p-layer: 30 nm
   Crystalline silicon n-layer: 30 nm
Third cell layer
   Crystalline silicon p-layer: 30 nm
   Crystalline silicon n-layer: 30 nm
First intermediate contact layer (GZO film): 0.03 µm
(average film thickness)
Second intermediate contact layer (GZO film): 0.06 µm
(average film thickness)
Back-side transparent layer
GZO film: 0.23 µm
SiO₂ film: 0.02 µm
Back electrode layer (Ag film): 160 nm
The surface shape of each layer was set using the surface shape representative values described above for the second embodiment.

The film thickness for the i-layer of each cell layer required to achieve a cell short-circuit current of 11 mA/cm² when the Ge concentration of the silicon germanium i-layer of the third cell layer was set to a value within a range from 10% to 35% was measured by optical analysis using a FDTD method.

### Comparative example

For a triple solar cell having the same structural model as that illustrated in FIG. 21, with the exceptions of setting the thickness values for the first intermediate contact layer and the second intermediate contact layer to 0 nm (namely, not providing the first and second intermediate contact layers), using only a GZO film of thickness 80 nm as the back-side transparent layer, and setting the pitch of the textured structure of the transparent electrode layer to 0.3 µm, the composition and film thickness of each layer were set in the same manner as that described for example 2. Further, in this comparative example, the surface shape employed for each layer in example 2 was not replicated, but rather, a surface shape parallel to the immediately underlying layer was adopted for each layer. Furthermore, the Ge concentration of the silicon germanium i-layer of the third cell layer was set to 40%.
For the triple solar cell of this comparative example, the film thickness for the i-layer of each cell layer required to achieve a cell short-circuit current of 11 mA/cm² was measured by optical analysis using a FDTD method.

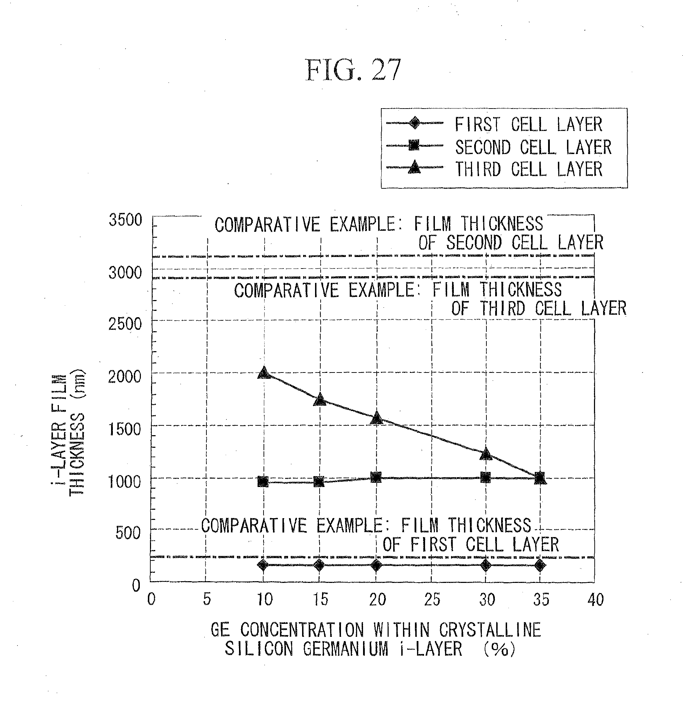

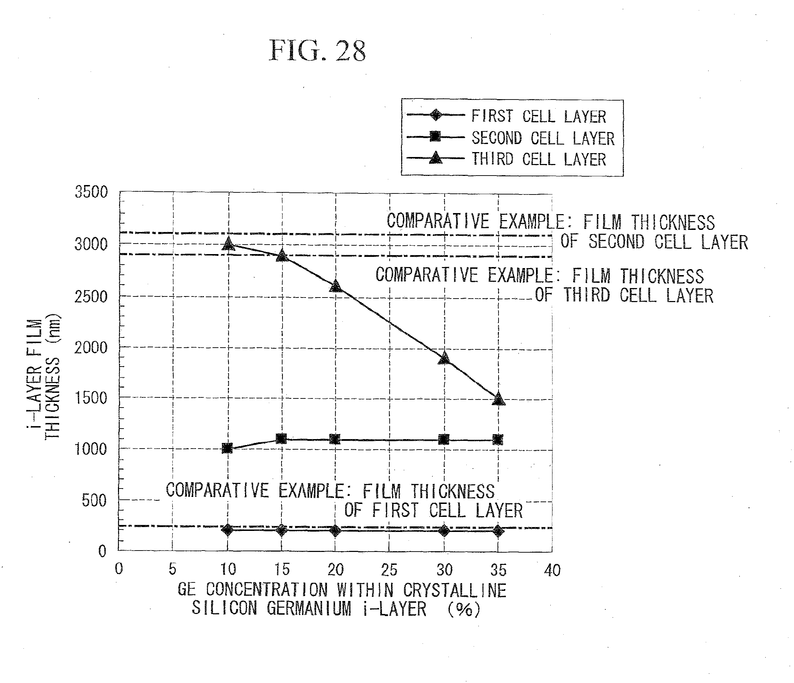

FIG. 27 illustrates the film thickness of the i-layer within each cell layer required to realize a short-circuit current of 11 mA/cm² at various Ge concentration values for triple solar cells of example 1 and the comparative example. FIG. 28 illustrates the film thickness of the i-layer within each cell layer required to realize a short-circuit current of 11 mA/cm² at various Ge concentration values for triple solar cells of example 2 and the comparative example. In both figures, the horizontal axis represents the Ge concentration, and the vertical axis represents the i-layer film thickness.

In all of the structures, the film thickness of the first cell layer i-layer was substantially the same.
In the solar cells of example 1 and example 2, the film thickness of the second cell layer i-layer was able to be substantially reduced from the thickness employed in the comparative example. The second cell layer i-layer in the examples exhibited almost no change with changing Ge concentration.
In example 1, the film thickness of the third cell layer i-layer was able to be reduced from the thickness employed in the comparative example. In particular, when the Ge concentration was within a range from 10% to 35%, the film thickness of the third cell layer i-layer was 2,000 nm or less, which represents a substantial reduction in the film thickness. The sum of the film thicknesses for the i-layers of the three cell layers was only 3,120 nm even at the largest value that occurred when the Ge concentration was 10%, which represents a reduction from the sum of the film thicknesses for the i-layers of the three cell layers in the comparative example (6,230 nm).
In example 2, by setting the Ge concentration to a value within a range from 15% to 35%, the film thickness of the third cell layer i-layer was able to be reduced to a value equal to or less than the film thickness in the comparative example. Further, the sum of the film thicknesses for the i-layers of the three cell layers was only 4,200 nm even at the largest value that occurred when the Ge concentration was 10% or 15%, which represents a reduction from the sum of the film thicknesses for the i-layers of the three cell layers in the comparative example.
In this manner, although the solar cells of the examples exhibit the same electrical current output as the solar cell of the comparative example, the film thickness of the i-layer within each cell layer is able to be reduced, meaning a reduction in costs can be achieved. In particular, because the film thickness of the silicon germanium i-layer of the third cell layer is able to be reduced, a significant cost reduction can be achieved.

## Claims

1. A photovoltaic device comprising at least a transparent electrode layer, a photovoltaic layer and a back electrode layer provided on a substrate, wherein
a surface of the transparent electrode layer on which the photovoltaic layer is disposed comprises a textured structure composed of ridges and a fine micro-texture provided on a surface of the ridges, and
a pitch of the textured structure provided on the transparent electrode layer is not less than 1.2 µm and not more than 1.6 µm.

2. The photovoltaic device according to claim 1, wherein a height of the ridges is not less than 0.2 µm and not more than 0.8 µm.

3. The photovoltaic device according to claim 1, wherein a pitch between peaks in the fine micro-texture is not less than 0.05 µm and not more than 0.14 µm.

4. The photovoltaic device according to claim 1, wherein a height of peaks in the fine micro-texture is not less than 0.02 µm and not more than 0.1 µm.

5. The photovoltaic device according to any one of claim 1 to claim 4, wherein
the photovoltaic layer comprises at least a first cell layer closest to the substrate, and a second cell layer that is formed on top of the first cell layer,
a first intermediate contact layer is provided between the first cell layer and the second cell layer, and a surface of the first intermediate contact layer on which the second cell layer is disposed has a textured structure represented by a sine curve,
an average film thickness of the first intermediate contact layer is not less than 0.03 µm and not more than 0.09 µm, and
a height of the textured structure of the first intermediate contact layer is not less than 0 µm and not more than 0.42 µm.

6. The photovoltaic device according to claim 5, wherein
the photovoltaic layer further comprises a third cell layer formed on top of the second cell layer,
a second intermediate contact layer is provided between the second cell layer and the third cell layer, and a surface of the second intermediate contact layer on which the third cell layer is disposed has a textured structure represented by a sine curve,
an average film thickness of the second intermediate contact layer is not less than 0.03 µm and not more than 0.09 µm, and
a height of the textured structure of the second intermediate contact layer is not less than 0.22 µm and not more than 0.7 µm.

7. The photovoltaic device according to any one of claim 1 to claim 6, wherein the photovoltaic layer comprises a crystalline silicon germanium i-layer, and a germanium concentration within the crystalline silicon germanium i-layer is not less than 10 atomic% and not more than 35 atomic%.

8. A photovoltaic device comprising at least a transparent electrode layer, a photovoltaic layer and a back electrode layer provided on a substrate, wherein
a surface of the transparent electrode layer on which the photovoltaic layer is disposed comprises a V-shaped textured structure,
a pitch of the textured structure provided on the transparent electrode layer is not less than 0.3 µm and not more than 5 µm, and a slope of a peak in the textured structure on the transparent electrode layer relative to a plane parallel to the substrate is not less than 15° and not more than 60°,
the photovoltaic layer comprises a crystalline silicon germanium i-layer, and a germanium concentration within the crystalline silicon germanium i-layer is not less than 10 atomic% and not more than 35 atomic%.

9. A substrate for a photovoltaic device, wherein
a transparent electrode layer comprising a transparent oxide is provided on the substrate,
a surface of the transparent electrode layer on an opposite side to the substrate comprises a textured structure composed of ridges and a fine micro-texture provided on a surface of the ridges,
a pitch of the textured structure on the transparent electrode layer is not less than 1.2 µm and not more than 1.6 µm, and a height of the ridges is not less than 0.2 µm and not more than 0.8 µm,
a pitch between peaks in the fine micro-texture is not less than 0.05 µm and not more than 0.14 µm, and a height of the peaks is not less than 0.02 µm and not more than 0.1 µm.
